## Europäisches Patentamt
## European Patent Office
## Office européen des brevets

(11) Publication number: **0 145 203**
**B1**

# EUROPEAN PATENT SPECIFICATION

(45) Date of publication of patent specification: **16.05.90**

(51) Int. Cl.⁵: **H 01 S 3/19, H 01 S 3/08**

(21) Application number: **84307353.7**

(22) Date of filing: **25.10.84**

(54) Semiconductor laser.

(30) Priority: **25.10.83 JP 200261/83**

(43) Date of publication of application:
**19.06.85 Bulletin 85/25**

(45) Publication of the grant of the patent:
**16.05.90 Bulletin 90/20**

(84) Designated Contracting States:
**DE GB NL**

(56) References cited:
**EP-A-0 026 062**

**JAPANESE JOURNAL OF APPLIED PHYSICS,
vol. 21, no. 10, part 2, October 1982, pages
L642-L644, Tokyo, JP; T. HAYAKAWA et al.:
"Multimode-oscillating behavior in index-
guiding V-channeled substrate inner stripe
lasers depending on structural factor"
JOURNAL OF APPLIED PHYSICS, vol. 53, no. 11,
part 1, November 1982, pages 7224-7234,
American Insitute of Physics, New York, US; T.
HAYAKAWA et al.: "Highly reliable and mode-**

(73) Proprietor: **SHARP KABUSHIKI KAISHA
22-22 Nagaike-cho Abeno-ku
Osaka 545 (JP)**

(72) Inventor: **Matsui, Sadayoshi
289-53 Nishinagara-cho
Tenri-shi Nara-ken (JP)**
Inventor: **Kaneiwa, Shinji
Akebono-ryo 2613-1 Ichinomoto-cho
Tenri-shi Nara-ken (JP)**
Inventor: **Takiguchi, Haruhisa
4-8-18 Noe, Jyoto-ku
Osaka-shi Osaka-fu (JP)**
Inventor: **Taneya, Mototaka
173-11 Kitanoda
Sakai-shi Osaka-fu (JP)**

(74) Representative: **Wright, Peter David John et al
R.G.C. Jenkins & Co. 26 Caxton Street
London SW1H 0RJ (GB)**

Courier Press, Leamington Spa, England.

**EP 0 145 203 B1**

(56) References cited:

stabilized operation in V-channeled substrate inner stripe lasers on p-GaAs substrate emitting in the visible wavelength region"
OPTICAL AND QUANTUM ELECTRONICS, vol. 12, 1980, pages 207-219, Chapman and Hall Ltd., London, GB; G. ARNOLD et al.: "Intrinsic noise of semiconductor lasers in optical communication systems"
IEEE JOURNAL OF QUANTUM ELECTRONICS, vol. QE-19, no. 10, October 1983, pages 1530-1536, IEEE, New York, US; T. HAYAWAKA et al.: "Mode characteristics of large-optical-cavity V-channeled substrate inner stripe injection lasers"
IEEE Journal of Quantum Electronics, vol.QE 18, no.1, Jan.1982, pages 22-29

## Description

The present invention relates to a semiconductor laser and more particularly to a semiconductor laser structure which minimizes mode competition noise at the desired operating temperature.

A semiconductor laser oscillating in a single longitudinal mode is widely used as a light source in optical information processing systems such as for example information recording/drawing disc systems. However, in hitherto known semiconductor lasers there has been a problem caused by the occurrence of unstable longitudinal mode transition and mode competition noise which is generated when the ambient temperature rises. The mode competition noise thus produced makes accurate operation of the optical information processing system difficult.

A prior art laser is discussed in the Japanese Journal of Applied Physics, Vol. 21, No. 10, Part 2, October 1982, pages L642 to L644. The laser discussed in this document is an index guided semiconductor laser having an inner stripe structure comprising first and second GaAlAs cladding layers and a GaAlAs active layer sandwiched therebetween. The paper discusses longitudinal mode behaviour in the laser and how this depends on structural factors of the laser by examining the effect of increasing current in the laser on the output power and noise power of the laser.

Another laser is discussed in the IEEE Journal of Quantum Electronics, Vol. QE—18, No. 1, January 1982, pages 22 to 29. The laser discussed in this document is a stripe GaInAsP/InP laser with chemically etched mirror surfaces. The paper discusses fabrication of such lasers, and the reflectivity obtainable on the mirrored surfaces.

Thus, the closest prior art of which we are aware provides an index guided semiconductor laser having an inner stripe structure and comprising first and second cladding layers and an active layer sandwiched by said first and second cladding layers.

The present invention aims to provide a solution to the problem of mode competition noise at desired operating temperatures which are relatively high.

The present invention is characterised in that the first and second cladding layers and the active layer have respective predetermined mole fractions selected to reduce the occurrence of mode competition noise at the desired operating temperature of the laser, and front and rear facets are provided on the laser, which front and rear facets have reflectivities of $R_1$ and $R_2$ respectively which satisfy the condition

$$0.1 \leq \ln(1/R_1 \cdot R_2) \leq 1.0$$

Further inventive features are set forth with particularity in the appended subordinate claims.

In a preferred embodiment of the present invention to be described in greater detail hereinafter the mole fraction of the cladding layers and the cavity length of the laser are selected such that the mode competition noise occurs at a temperature higher than the desired operating temperature. The mode competition noise is minimized by the invention, making the semiconductor laser particularly suitable as a light source in an optical information processing system.

In order that the invention may be better understood, an embodiment will be described, by way of example only, with reference to the accompanying drawings, in which:

Figure 1 is a graph showing the signal-to-noise (S/N) ratio of a laser beam emitted from a typical known semiconductor laser, the S/N ratio varying depending on the ambient temperature;

Figure 2 is a perspective view of an embodiment of a V-channelled substrate inner stripe (VSIS) semiconductor laser in accordance with the present invention;

Figure 3 is a graph showing the temperature at which mode competition noise occurs when the mole fraction of a cladding layer is changed;

Figure 4 is a graph showing the temperature at which mode competition noise occurs when the cavity length is changed; and

Figure 5 is a graph showing the temperature at which mode competition noise occurs when the reflectivity of a cleaved facet is changed.

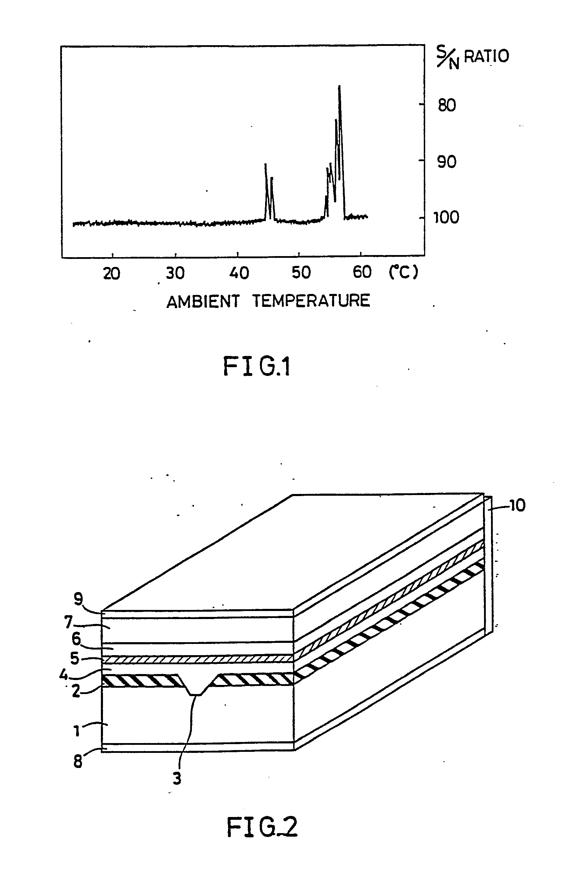

Referring now to Figure 1 of the accompanying drawings, which shows the S/N ratio of the laser output varying depending on the ambient temperature, it can be seen that the mode competition noise occurs when the lasing longitudinal mode changes between a plurality of longitudinal modes. Generally, mode competition noise occurs when the semiconductor laser is operated at a relatively high temperature. In Figure 1, the mode competition noise occurs when the ambient temperature rises above 45°C. When the mode competition noise occurs, the S/N ratio of the laser output (centre frequency 8 MHz with 10 KHz bandwidth) reduces to between 70 and 80 dB. Accordingly, the laser beam from a laser with this mode competition noise is not well suited for use as the light source in an optical information processing system.

An index guided semiconductor laser generally oscillates in a single longitudinal mode at room temperature. However, mode competition noise occurs as the ambient temperature rises. An index guided semiconductor laser having an inner stripe structure, such as a V-channelled substrate inner stripe (VSIS) semiconductor laser wherein an optical wave guide and a current confinement structure are formed at a same time, shows stable operation as compared with an index guided semiconductor laser having a planar structure. An index guided inner stripe semiconductor laser generally includes a current blocking layer formed on a substrate. A V-shaped groove is formed in the current blocking layer, which operates as a current path. A multi-layered crystal is formed on the current blocking layer. The index guided inner stripe semiconductor laser ensures more stable operation because the transverse optical intensity distribution in the optical waveguide and the carrier distribution in the active layer caused by the injection current coincide with each other. Furthermore, the index guided inner stripe semiconductor laser does not produce mode competition noise even at a relatively high temperature, for example, 40°C through 50°C. However, when the semiconductor laser is installed in an optical information processing system, the ambient temperature is usually between about 50°C to 60°C. Thus, there is a great possibility that mode competition noise will occur in known index guided inner stripe semiconductor lasers when one of such lasers is used as the light source in an optical information processing system.

Figure 2 shows a GaAs—GaAlAs V-channelled substrate inner stripe (VSIS) semiconductor laser embodying the present invention. A Te doped n-GaAs current blocking layer 2 having a carrier density of $2 \times 10^{18}$ cm$^{-3}$ is formed, through the use of a liquid phase epitaxial growth method, to a thickness of about 0.8 μm on a Zn doped p-GaAs substrate 1 having a carrier density of $1 \times 10^{18}$ cm$^{-3}$. A V-shaped groove 3 is formed in the current blocking layer 2 to reach the substrate 1 through the use of a suitable etching method. The V-shaped groove 3 preferably has a width of about 3 through 4 μm, and the V-shaped groove 3 functions as a current path. A plurality of V-shaped grooves 3 are formed in the current blocking layer 2 with a pitch of 300 μm. A Mg doped p-Ga$_{1-x}$Al$_x$As first cladding layer 4 is formed on the current blocking layer 2 to a thickness of about 0.1 μm through 0.2 μm by a liquid phase epitaxial growth method. Then, a Mg doped p-Ga$_{1-y}$Al$_y$As active layer 5 with a thickness of about 0.1 μm is formed on the first cladding layer 4 by a liquid phase epitaxial growth method. Further, a Te doped n-Ga$_{1-x}$Al$_x$As second cladding layer 6 of a thickness of 1 μm is formed on the active layer 5 by a liquid phase epitaxial growth method. Finally, a Te doped n-GaAs cap layer 7 is formed on the second cladding layer 6 to a thickness of about 3 μm by a liquid phase epitaxial growth method. A p-electrode 8 and an n-electrode 9 are secured to the p-GaAs substrate 1 and the n-GaAs cap layer 7, respectively, by evaporation. The thus formed wafer is divided into 300 μm strips with the V-shaped groove 3 positioned at the centre of the strip. Cleaved facets are then formed at the both ends of the thus produced laser device and a multi-layered reflection film 10 is deposited on both of the cleaved facets by evaporation. Laser oscillation occurs when a carrier is injected into the laser from the p-electrode 8 and the n-electrode 9.

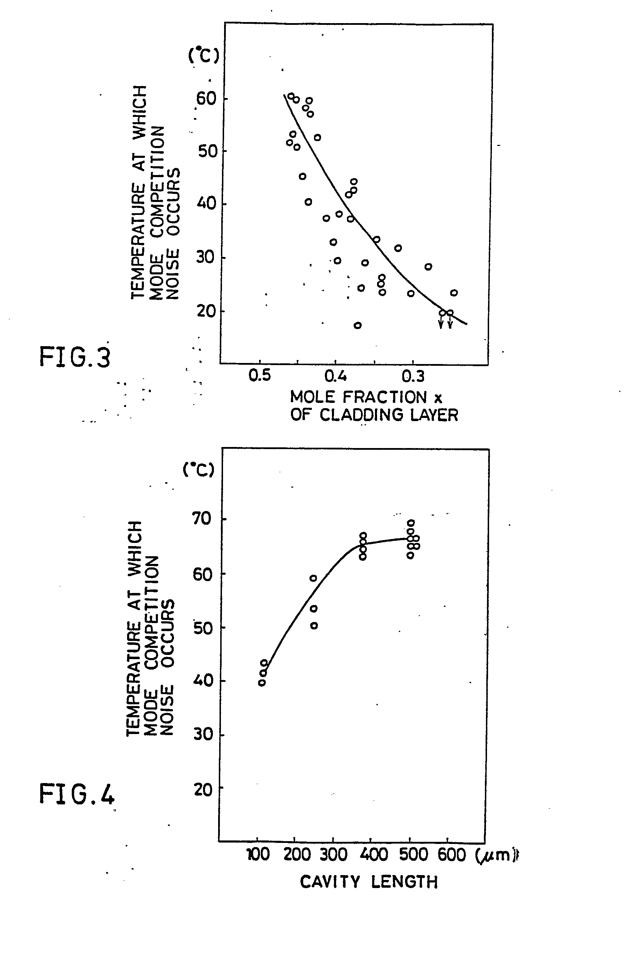

Figure 3 shows the temperature at which the mode competition noise occurs when the AlAs mole fraction x of the first and second cladding layers 4 and 6 is changed. For this graph the measurement was carried out when the VSIS semiconductor laser of the construction of Figure 2 was emitting a 3 mW laser beam. The VSIS semiconductor laser used herein had a cavity length of 250 μm, and the cleaved facets on both ends had the same reflectivity R$_1$ and R$_2$ of 0.32. It will be clear from Figure 3 that mode competition noise does not occur below 50°C when the mole fraction x is selected to be higher than about 0.45. On the other hand, if the mole fraction x of the cladding layers is selected to be higher than about 0.52, it is difficult to form the index guide by the waveguide mechanism based on the effective refractive index approximation. That is to say, a gain guide is formed instead of the index guide and the laser oscillation occurs in a multiple longitudinal mode. Therefore, the AlAs mole fraction x of the first and second cladding layers should be selected between about 0.45 and 0.52 so as to ensure the single longitudinal mode oscillation without the mode competition noise.

Figure 4 shows the temperature at which the mode competition noise occurs when the cavity length is changed in the VSIS semiconductor laser of the abovementioned construction wherein the AlAs mole fraction x of the first and second cladding layers is selected beween 0.45 and 0.52. For this graph, the output power was set at 3 mW, and the cleaved facets on both ends had the same reflectivity R$_1$ and R$_2$ of 0.32. It should be clear from Figure 4 that mode competition noise does not occur when the ambient temperature is less than 60°C if the cavity length is arranged to be longer than about 300 μm, even though the normal cavity length of the conventional semiconductor laser is 250 μm through 300 μm.

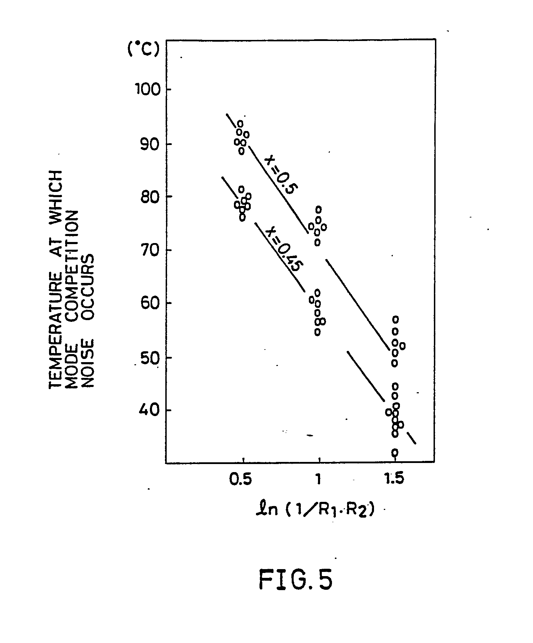

Figure 5 shows the temperature at which the mode competition noise occurs when the reflectivities R$_1$ and R$_2$ at the cleaved facets are changed while the AlAs mole fraction x of the first and second cladding layers is selected at 0.45 or 0.5. The reflectivity R$_1$ represents the reflectivity of the front facet, and R$_2$ represents the reflectivity of the rear facet. Generally, R$_2$ can be greater than or equal to R$_1$. For this graph the laser beam output level was 3 mW, and the cavity length was 250 μm. It should be clear from Figure 5 that mode competition noise does not occur below 75°C even in a semiconductor laser of conventional construction if the reflectivities R$_1$ and R$_2$ are selected to satisfy the following condition.

$$\ln(1/R_1 . R_2) \leq 1$$

However, if $\ln(1/R_1 . R_2)$ is less than 0.1, the laser output is not effectively emitted from the front facet. Accordingly, the reflectivities R$_1$ and R$_2$ should be selected to satisfy the following condition.

$$0.1 \leq \ln(1/R_1 . R_2) \leq 1$$

The concept of the present invention is applicable to compound semiconductor lasers such as GaP lasers or GaAlP lasers in addition to the above discussed GaAs—GaAlAs semiconductor laser.

The invention being thus described, it will be obvious that the same may be varied in many ways. Such variations are not to be regarded as a departure from the scope of the invention. There are described above novel features which the skilled man will appreciate give rise to advantages.

## Claims

1. An index guided semiconductor laser having an inner stripe structure and comprising first and second cladding layers (4, 6) and an active layer (5) sandwiched by said first and second cladding layers (4, 6) characterised in that the first and second cladding layers (4, 6) and the active layer (5) have respective predetermined mole fractions (x, y) selected to reduce the occurrence of mode competition noise at the desired operating temperature of the laser, and front and rear facets are provided on the laser, which front and rear facets have reflectivities of $R_1$ and $R_2$ respectively which satisfy the condition

$$0.1 \leq \ln(1/R_1 . R_2) \leq 1.0$$

2. A semiconductor laser according to claim 1, characterised in that said semiconductor laser has a cavity length which minimises the occurrence of mode competition noise at the desired operating temperature.

3. A semiconductor laser according to claim 1 or 2, characterised in that the laser is a V-channelled inner stripe (VSIS) semiconductor laser.

4. A semiconductor laser according to claim 3, characterised in that the first cladding layer (4) is composed of p-$Ga_{1-x}Al_xAs$ material, the active layer (5) is composed of p-$Ga_{1-y}Al_yAs$ material formed on the first cladding layer, and the second cladding layer (6) is composed of n-$Ga_{1-x}Al_xAs$ formed on the active layer, where the mole fraction x is selected to be between about 0.45 and 0.52.

5. A semiconductor laser according to claim 4, characterised in that the first cladding layer (4) is formed on an n-GaAs current blocking layer (2) which in turn is formed on a p-GaAs substrate (1) with a substantially v-shaped groove (3) formed in the current blocking layer (2) and extending therethrough into said substrate (1) with the first cladding layer (4) occupying the said v-shaped groove (3) in contact with the current blocking layer (2) and the substrate (1).

6. A semiconductor laser according to claim 5, characterised in that the laser further comprises an n-GaAs capping layer (7) formed on the second cladding layer (6).

7. A semiconductor laser according to claim 6, characterised in that the cavity length is greater than about 300 µm.

## Patentansprüche

1. Indexgeführter Halbleiterlaser mit einer inneren Streifenstruktur, einer ersten und einer zweiten Abdeckschicht (4, 6) und einer zwischen diesen beiden Abdeckschichten (4, 6) angeordneten aktiven Schicht (5), dadurch gekennzeichnet, daß die Molfraktionen (x, y) der ersten bzw. zweiten Deckschicht (4, 6) bzw. der aktiven Schicht (5) im Hinblick auf eine Verminderung des Auftretens von Moden-(Konkurrenz-)Rauschen bei der gewünschten Betriebstemperatur des Lasers gewählt werden und daß der Laser mit vorder- und rückseitigen Facetten versehen ist, deren Reflexionsvermögen $R_1$ bzw. $R_2$ die Bedingungen erfüllt

$$0,1 \leq \ln(1/R_1 \cdot R_2) \leq 1,0.$$

2. Halbleiterlaser nach Anspruch 1, dadurch gekennzeichnet, daß die Resonator- bzw. Kammerlänge des Halbleiterlasers so gewählt ist, daß das Auftreten von Modenkonkurrenzrauschen bei der gewünschten Betriebstemperatur minimisiert ist.

3. Halbleiterlaser nach Anspruch 1 oder 2, dadurch gekennzeichnet, daß der Laser eine innere V-kanalförmige Streifenstruktur (VSIS = V-Channeled Inner Stripe) aufweist.

4. Halbleiterlaser nach Anspruch 3, dadurch gekennzeichnet, daß die erste Abdeckschicht (4) aus einer p-$Ga_{1-x}Al_xAs$-Materialzusammensetzung, die aktive Schicht (5) aus einer auf der ersten Abdeckschicht aufgebrachten p-$Ga_{1-y}Al_yAs$-Materialzusammensetzung und die auf der aktiven Schicht aufgebrachte zweite Abdeckschicht (6) aus einer n-$Ga_{1-x}Al_xAs$-Zusammensetzung besteht, wobei die Molfraktion x zwischen etwa 0,45 und 0,52 gedwählt ist.

5. Halbleiterlaser nach Anspruch 4, dadurch gekennzeichnet, daß die erste Abdeckschicht (4) über einer n-GaAs-Stromsperrschicht (2) ausgebildet ist, die ihrerseits auf einem p-GaAs-Substrat (1) ausgebildet ist, wobei die Stromsperrschicht (2) eine im wesentlichen V-förmige Nut (3) aufweist, so daß sich die erste Abdeckschicht (4) durch die Stromsperrschicht (2) hindurch in das Substrat (1) hinein erstreckt, derart, daß die erste Abdeckschicht (4) die V-förmige Nut (3) ausfüllt und dabei in Kontakt mit der Stromsperrschicht (2) und dem Substrat (1) steht.

6. Halbleiterlaser nach Anspruch 5, dadurch gekennzeichnet, daß der Laser außerdem eine auf der zweiten Abdeckschicht (6) ausgebildete n-GaAs-Deckschicht (7) aufweist.

7. Halbleiterlaser nach Anspruch 6, dadurch gekennzeichnet, daß die Resonatorlänge größe ist als etwa 300 µm.

## Revendications

1. Laser à semiconducteurs à guidage d'indice comportant une structure intérieure en forme de bande et comportant des première et seconde couches de revêtement (4, 6) et une couche active (5) enserrée entre lesdites première et second couches de revêtement (4, 6), caractérisé en ce que les première et seconde couches de revêtement (4, 6) et la couche active (5) possèdent des fractions molaires respectives prédéterminées (x, y) choisies de manière à réduire l'apparition d'un bruit de concurrence des modes, à la température de fonctionnement désirée du laser, et en ce que des facettes avant et arrière sont prévues sur le laser, lesquelles facettes avant et arrière possèdent des coefficients de réflexion respectifs ($R_1$ et $R_2$), qui satisfont à la condition

$$0,1 \leq \ln(1/R_1 \cdot R_2) \leq 1,0$$

2. Laser à semiconducteurs selon la revendication 1, caractérisé en ce que ledit laser à semiconducteurs possède une longueur de cavité qui réduit l'apparition d'un bruit de concurrence des modes à la température de fonctionnement désirée.

3. Laser à semiconducteurs selon l'une des revendications 1 ou 2, caractérisé en ce que le laser est un laser à semiconducteurs à bande intérieure à canal en V (VSIS).

4. Laser à semiconducteurs selon la revendication 3, caractérisé en ce que la première couche de revêtement (4) est constituée d'un matériau $Ga_{1-x}Al_xAs$ de type p, la couche active (5) est constituée par un matériau $Ga_{1-y}Al_yAs$ de type p formé sur la première couche de revêtement, et la seconde couche de revêtement (6) est constituée par du $Ga_{1-x}Al_xAs$ de type n, formée sur la couche active, la fraction molaire x étant choisie de manière à être comprise entre environ 0,45 et 0,52.

5. Laser à semiconducteurs selon la revendication 4, caractérisé en ce que la première couche de revêtement (4) est formée sur une couche (2) de blocage du courant, en GaAs de type n, qui à son tour est formée sur un substrat (1) en GaAs de type p, qui possède une rainure sensiblement en forme de v (3) ménagée dans la couche (2) de blocage du courant et traversant cette couche pour pénétrer dans ledit substrat (1), la première couche de revêtement (4) occupant ladite rainure en forme de v (3), en étant en contact avec la couche (2) de blocage du courant et avec le substrat (1).

6. Laser à semiconducteurs selon la revendication 5, caractérisé en ce que le laser comporte en outre une couche de recouvrement (7) en GaAs de type n, formée sur la seconde couche de revêtement (6).

7. Laser à semiconducteurs selon la revendication 6, caractérisé en ce que la longueur de la cavité est supérieure à environ 300 µm.

FIG.1

FIG.2

1

FIG.3

FIG.4

FIG.5